# EUROPÄISCHE PATENTSCHRIFT

(11) **EP 2 387 737 B1**
(45) Veröffentlichungstag und Bekanntmachung des Hinweises auf die Patenterteilung: **25.06.2014**
(21) Anmeldenummer: 09778965.5
(22) Anmeldetag: 20.01.2009
(51) Int. Cl.: F02C 7/266, G01R 19/00, G05B 13/02, F02P 17/12

(54) **VERFAHREN UND MESSEINRICHTUNG ZUR ERMITTLUNG EINES ZUSTANDS EINES ELEKTRISCHEN ZÜNDERS EINES GASTURBINENBRENNERS SOWIE ZÜNDEINRICHTUNG FÜR EINEN GASTURBINENBRENNER**
METHOD AND MEASUREMENT DEVICE FOR DETERMINING A CONDITION OF AN ELECTRIC IGNITER OF A GAS TURBINE BURNER AND AN IGNITION DEVICE FOR A GAS TURBINE BURNER
PROCÉDÉ ET DISPOSITIF DE MESURE POUR DÉTERMINER UN ÉTAT D'UN ALLUMEUR ÉLECTRIQUE D'UN BRÛLEUR DE TURBINE À GAZ, AINSI QUE DISPOSITIF D'ALLUMAGE POUR UN BRÛLEUR DE TURBINE À GAZ

(30) Priorität: 21.11.2008 DE 102008058571
(43) Veröffentlichungstag der Anmeldung: 23.11.2011
(73) Patentinhaber: Siemens Aktiengesellschaft, 80333 München (DE)
(72) Erfinder: GONDER, Jörg, 45470 Mülheim an der Ruhr (DE)
(86) Internationale Anmeldenummer: PCT/EP2009/050578
(87) Internationale Veröffentlichungsnummer: WO 2010/057680

(56) Entgegenhaltungen:
- DE-A1- 19 524 499
- US-A- 4 760 341
- US-A- 6 085 144
- US-A1- 2003 168 049

## Beschreibung

Die Erfindung betrifft ein Verfahren zur Ermittlung eines Zustands eines elektrischen Zünders eines Gasturbinenbrenners, bei dem in einem ersten Schritt ein zeitabhängiges, den Zündstrom eines Zünders charakterisierendes Signal mit einem oberen Grenzwert und einem unteren Grenzwert verglichen wird. Ferner betrifft die Erfindung eine Messeinrichtung zur Ermittlung eines Zustands eines elektrischen Zünders eines Gasturbinenbrenners, umfassend einen Sensor zur zeitaufgelösten Erfassung des Stroms eines elektrischen Zünders eines Gasturbinenbrenners und eine mit dem Sensor gekoppelte Auswerteeinrichtung mit zumindest einem Speicher und mit zumindest einem Mittel zum Vergleichen des vom Sensor bereitgestellten Signals mit zumindest einem im Speicher abgelegten Grenzwert. Darüber hinaus betrifft die Erfindung eine Zündeinrichtung für einen Gasturbinenbrenner, umfassend einen zwei einander gegenüberliegende Elektroden aufweisenden Zünder, zwischen welchen Elektroden ein Zündfunken mittels einer Zündspannung erzeugbar ist und einen Zündtransformator zur Erzeugung der Zündspannung, welcher Zündtransformator sekundärseitig mit den Elektroden elektrisch verbunden ist.

Ein die Erfindung betreffender Zünder eines Gasturbinenbrenners ist beispielsweise aus der EP 1 892 474 A1 bekannt. Der darin beschriebene Brenner umfasst einen Pilotbrenner, der mit Hilfe eines Zünders gezündet werden kann, alsbald durch den Pilotbrenner ein brennbares Gas oder brennbares Stoffgemisch in die Brennkammer einer Gasturbine einströmt. Der daraus bekannte Zünder umfasst im Wesentlichen zwei parallel zueinander verlaufende Zündelektroden, die im Bereich des Brennstoffaustritts des Pilotbrenners zueinander gekrümmt sind und dort ihren geringsten Abstand aufweisen, um im Bereich des Brennstoffaustritts einen Zündfunken erzeugen zu können, mittels dem der Brennstoff bzw. das Gemisch gezündet werden kann. Üblicherweise wird zur Erzeugung des Zündfunkens eine ausreichend hohe Wechselspannung an die beiden Elektroden angelegt, welche von einem Zündtransformator bereitgestellt wird. Die Zündspannung kann dabei mehrere Kilovolt (kV) betragen.

Beschädigungen oder Verbiegungen einer oder beider am Pilotbrenner angebrachten Zündelektroden beim Transport oder Einbau können die Funktionstüchtigkeit der Zündelektroden negativ beeinflussen. Des Weiteren können aufgrund thermisch bedingter Dehnungen Risse in der Isolierung der Zündelektroden auftreten oder die Zündelektroden können schlimmstenfalls brechen, so dass trotz anliegender Zündspannung der Zünder am Brennstoffaustritt des Pilotbrenners kein Zündfunken bereitstellt. Gleichfalls ist es möglich, dass nach einer sogenannten Off-Line-Verdichterwäsche die Elektroden noch mit einer Verdichterwaschflüssigkeit benetzt sind, was das Entstehen eines Zündfunkens trotz anliegender Zündspannung aufgrund sich einstellender Kriechströme ebenfalls verhindert. Diese Fehler können zu unerwünschten und für die Gasturbine möglicherweise schädlichen Fehlstarts führen.

Zur Überwachung der Zünder und des Zündfunkens ist aus der US 4, 760, 341 eine Vorrichtung bekannt. Die Vorrichtung überwacht die Zeitdauer und die Amplitude des Zündfunkens sowie den negativen Anteil der Wellenform der Funkenentladung. Der Zünderzustand bzw. der Zündfunken wird als bestimmungsgemäß erkannt, wenn die Zeitdauer des Zündfunkens eine Maximalzeit nicht überschreitet, die Amplitude des Zündfunkens eine Mindestgröße aufweist und gleichzeitig der negative Anteil einen akzeptablen Mindestwert überschreitet. Nachteilig ist, dass diese Vorrichtung nicht geeignet ist, den Zündvorgang bei Gasturbinen zu überwachen.

Demnach liegt der Erfindung die Aufgabe zu Grunde, eine Zündeinrichtung für einen Gasturbinenbrenner anzugeben, mittels der der Zustand eines elektrischen Zünders eines Gasturbinenbrenners einfach und zuverlässig ermittelt werden kann. Weitere Aufgabe der Erfindung ist die Angabe eines wirkungsvollen Verfahrens zur Ermittlung des Zustands des elektrischen Zünders des Gasturbinenbrenners und eine Messeinrichtung dafür, um Fehlstart von Gasturbinen zu vermeiden.

Die auf das Verfahren gerichtete Aufgabe wird durch ein verfahren gemäß den Merkmalen des Anspruchs 1 gelöst. Die auf eine Messeinrichtung gerichtete Aufgabe wird mit einer solchen gemäß den Merkmalen des Anspruchs 11 und die auf eine Zündeinrichtung gerichtete Aufgabe wird mit einer solchen gemäß den Merkmalen des Anspruchs 13 gelöst.

Der Erfindung liegt insgesamt die Erkenntnis zu Grunde, dass beim Zünden des Zünders eines Gasturbinenbrenners an dessen Spitze ein lichtbogenartiger Zündfunken entsteht, dessen Stromgröße spezifisch ist. Da vor dem Öffnen der Brennstoffventile des Pilotbrenners oder auch eines Hauptbrenners des Gasturbinenbrenners für eine Mindestdauer der Zündfunken am Zünder bereitstehen muss, bietet sich die Überwachung des dabei fließenden Zündstroms an, um festzustellen, in welchem Zustand sich der elektrische Zünder des Gasturbinenbrenners befindet. Das erfindungsgemäße Verfahren sieht vor, in einem ersten Schritt ein zeitabhängiges den Zündstrom eines Zünders charakterisierendes Signal mit einem oberen Grenzwert und einem unteren Grenzwert zu vergleichen, um festzustellen, ob der Zünder funktionsunfähig oder funktionsfähig ist. Darüber hinaus wird vorgeschlagen, dass in einem weiteren, gleichzeitig durchzuführenden Schritt das charakterisierende Signal mit einem Sollstrom-Mittelwert verglichen wird. Der Erfindung liegt nämlich weiter die Erkenntnis zu Grunde, dass das die Größe des Zündstroms und demnach die Größe des den Zündstrom charakterisierenden Signal nicht nur innerhalb eines vorbestimmten Toleranzbands liegen muss, sondern, dass der für die Dauer des Zündfunkens fließende Zündstrom, auch um einen Sollstrom-Mittelwert aufgrund des Flackerns des Lichtbogens bzw. Funkens schwanken muss. Folglich wird nicht nur der aktuelle Wert des Zündstroms auf Min-/Max-Unter- bzw. Überschreitung überwacht, sondern auch der zeitliche Verlauf des Zündstroms, um festzustellen, ob der Zünder funktionsfähig ist oder nicht. Tritt der sich bei fehlerfreier Zündeinrichtung einstellende, um den Sollstrom-Mittelwert schwankende Zündstrom nicht auf, so ist die betroffene Zündeinrichtung funktionsunfähig.

Erfindungsgemäß wird somit nicht nur der tatsächliche Zündstrom auf einen oberen Grenzwert und einen unteren Grenzwert in einem ersten Schritt untersucht, sondern auch auf einen Mittelwert, um den dieser bei funktionsfähigem Zünder in der Regel zufällig schwankt.

Sollte die Zündfähigkeit des Zünders durch Wasser beeinträchtigt worden sein, können Kurzschlüsse oder auch Kriechströme auftreten, die einen konstanten Stromfluss zur Folge haben, welcher somit nicht um den Sollstrom-Mittelwert alterniert, jedoch unter Umständen auch innerhalb des Toleranzbands zu finden ist. Aufgrund der Kurzschlüsse oder Kriechströme entsteht kein Zündfunke zwischen den Elektrodenspitzen. Auch kann es sein, dass nicht an der Elektrodenspitze, sondern irgendwo auf der Strecke zwischen Elektrode und Gasturbinengehäuse ein Zündfunken entsteht. Dieser Zündfunke liegt jedoch in einer Umgebung, in der er nicht durch den Luftmassenstrom des Verdichters beeinflusst wird, so dass das um den Sollstrom-Mittelwert alternierende Signal ausbleibt. Auch diese Fehler können durch das vorgeschlagene Verfahren als solche erkannt werden.

Durch die Verwendung des erfindungsgemäßen Verfahrens und der erfindungsgemäßen Vorrichtungen kann die Startverfügbarkeit von Gasturbinen weiter verbessert werden, da aufgrund der Kenntnisse über dem Zustand des Zünders bzw. der Zünder Fehlstarts wegen defekter oder nicht funktionsfähiger Zünder vermieden werden. Maßnahmen zur Behebung der ggf. temporären Funktionsunfähigkeit der Zünder und/oder zur Reparatur von defekten Zündern sind dann rechtzeitig durchführbar, ohne dass es durch diese zu Fehlstarts der Gasturbine kommt.

Der obere Grenzwert und der untere Grenzwert und/oder der Sollstrom-Mittelwert sind jeweils zeitabhängig. Folglich bilden die zeitabhängigen oberen und unteren Grenzwerte eine Sollstrom-Hüllkurve und der zeitabhängige Sollstrom-Mittelwert eine Sollstrom-Trend-Kennlinie. Dies ist insbesondere dann von Vorteil, wenn während der Bereitstellung des Zündfunkens (gleich Zünddauer) sich die Umgebungsbedingungen des Zündfunkens ändern, was auch eine Veränderung des Zündstroms nach sich zieht. Dies ist beispielsweise dann der Fall, wenn der Zündfunken während einer sich ändernden Drehzahl eines Rotors der Gasturbine bereitgestellt werden muss, da in Folge der sich ändernden Rotordrehzahl sich auch der vom Verdichter angesaugte Luftmassenstrom ändert. Der geänderte Luftmassenstrom führt gleichfalls zu einer Änderung der an den Zündern vorbeiströmende Luftmenge. Hierdurch wird der Zündfunken beeinflusst, was sich in der Größe des Zündstroms niederschlägt. Insofern ist es sinnvoll, für sich verändernde Randbedingungen des Zündfunkens variable und somit zeitabhängige Grenzwerte bzw. Mittelwerte dem Verfahren zugrunde zu legen, mit welchen der Zündstrom bzw. das den Zündstrom charakterisierende Signal verglichen wird.

Aufgrund der zunehmenden Rotordrehzahl beim Hochfahren der Gasturbine - noch vor dem Start der Gasturbine, d.h. noch vor der Verbrennung von Brennstoff - steigert sich der Luftmassenstrom, welcher an den Brennern entlang des Brenners geführt wird, so dass ein vorhandener Zündfunke durch den Luftzug beeinflusst wird, was zur Verringerung des Zündstromes führt.

Vorteilhafte Ausgestaltungen sind in den Unteransprüchen angegeben.

Gemäß einer vorteilhaften Ausgestaltung der Erfindung wird der Zustand des Zünders als nicht funktionsfähig ermittelt, wenn das charakterisierende Signal für eine erste Mindestdauer außerhalb des vom oberen Grenzwert und unteren Grenzwert gebildeten Intervalls liegt. Demnach soll das Überschreiten des oberen Grenzwerts oder das Unterschreiten des unteren Grenzwerts durch den Sollstromwert erst dann zu einer dem Betreiber angezeigten Meldung "Zünder nicht funktionsfähig" führen, wenn der Zündstrom für eine Mindestzeitspanne, vorzugsweise drei Sekunden, außerhalb des Intervalls liegt. Hierdurch sollen zufällige Fehlermeldungen und Falschanzeigen ausgeschlossen werden. Ebenso kann dadurch das Intervall auch enger gefasst werden als bei einem Verfahren, welches die Zeitdauer des Unter- bzw. Überschreitens des betreffenden Grenzwerts nicht überwacht.

Gemäß einem besonders bevorzugten Verfahren wird der Zustand des Zünders als nicht funktionsfähig ermittelt, wenn das charakterisierende Signal für eine zweite Mindestdauer nicht um den Sollstrom-Mittelwert bzw. Sollstrom-Trend-Kennlinie schwankt. Aufgrund der Abhängigkeit des Zündstrom von der Zufälligkeit des Zündfunkens und der ihn umgebenden Luftströmung kann der Zünderzustand als funktionsunfähig erkannt werden, wenn diese Zufälligkeit in der Größe des Zündstroms für eine zweite Mindestdauer, vorzugsweise drei Sekunden, ausbleibt. Mit anderen Worten: der Sollstrom-Mittelwert bzw. die Sollstrom-Trend-Kennlinie, welche(r) in der Regel mittig zwischen dem oberen Grenzwert und dem unteren Grenzwert angeordnet ist, stellt eine Größe dar, um die der sich tatsächlich einstellende Zündstrom zufällig schwankt, sofern ein Zündfunken an der vorgesehenen Zündposition von den beiden Elektroden des Zünders bereitgestellt wird. Wenn beispielsweise dagegen aufgrund eines Bruchs von Zündelektroden oder eines Isolationsfehlers einer Elektrode sich ein Kurzschlussstrom über den Brenner einstellt, bleibt ein um den Sollstrom-Mittelwert bzw. Sollstrom-Trend-Kennlinie schwankender Stromverlauf aus, was auf einen nicht funktionsfähigen Zünder hindeutet. Insofern bietet insbesondere die Überwachung des tatsächlichen Stromverlaufs auf einen zufällig um einen Sollstrom-Mittelwert bzw. Sollstrom-Trend-Kennlinie schwankenden Stromverlauf ein besonders effizientes Überwachungskriterium, mittels dem der Zustand des Zünders äußerst zuverlässig und sicher ermittelt werden kann.

Um einen vergleichsweise kleinen Zündstrom zu erfassen, ist es von Vorteil, wenn der primärseitige Strom eines Zündtransformators als Zündstrom erfasst wird, wenn ein Zündtransformator zur Erzeugung der Zündspannung der Zündelektroden vorgesehen ist. Hierdurch kann der Einsatz von handelsüblichen, räumlich kompakten Sensoren, beispielsweise Stromwandlern, Strommessumformern oder Hall-Effekt-Sensoren ermöglicht werden.

Anstelle oder ergänzend zum Vergleich, ob der tatsächlich auftretende, erfasste Zündstrom innerhalb der Sollstrom-Hüllkurve variiert, kann auch ein Mustervergleich von Stromverläufen durchgeführt werden, um festzustellen, ob der überwachte Zünder funktionsfähig ist oder nicht. Zu diesem Zweck wird vorab ein Referenzverlauf (Referenzmuster) des Zündstroms nach dem Abschalten der Gasturbine, d.h. nach dem Abschalten der Brennstoffzufuhr bei noch drehendem Rotor erfasst. In dieser Phase werden die Zünder gestartet und für einen vorgegebenen Zeitraum, beispielsweise 10 Sekunden, wird der Stromverlauf des Zünders gemessen und gespeichert. Das Referenzmuster kann danach mit Zündstromverläufen verglichen werden, die vor dem Starten der Gasturbine erfasst werden.

Vorzugsweise wird das Verfahren zur Ermittelung des Zustands des Zünders während der Drehung eines Rotors der Gasturbine oder vor dem Starten der Gasturbine durchgeführt. Hierdurch lässt sich die Zeitdauer bis zum Starten der Gasturbine reduzieren, da bereits während des Hochfahrens, aber bei noch nicht gezündeter Gasturbine die Überprüfung auf die Funktionsfähigkeit der Zünder erfolgt.

Üblicherweise ändert sich beim Hochfahren der Gasturbine die Rotordrehzahl des Rotors. In der Regel wird sie stetig erhöht. Um die Einflüsse der auf die Zündstrecke bzw. Zündfunken einwirkenden Randbedingungen vorab zu ermitteln, bietet es sich an, den Stromverlauf eines funktionsfähigen Zünders zu ermitteln, aus dem die Sollstrom-Trend-Kennlinie bestimmt wird. Um zu gewährleisten, dass der funktionsfähige Zünder in einem trockenen Zustand überprüft wird, soll die Ermittlung des Stromverlaufs, die der Sollstrom-Trend-Kennlinie zugrunde gelegt wird, nach dem Abschalten der

Gasturbine erfasst werden. Für die ermittelten Werte wird vorzugsweise mittels eines Polynoms eine Interpolation durchgeführt, aus welcher als Trend-Kennlinie ein Erwartungswert für den Sollstrom ermittelt werden kann, um welchen der Zündstrom in Realität schwankt. Sofern die Rotordrehzahl konstant bleibt, kann der Sollstrom-Mittelwert so ermittelt werden.

Gemäß einem weiteren vorteilhaften Verfahren der Erfindung wird jeder Zünder einer Gasturbine auf Funktionsfähigkeit überprüft, woraus sich die Anzahl der funktionsfähigen Zünder für die Gasturbine ergibt. Liegt die Anzahl der funktionsfähigen Zünder unterhalb einer Mindestanzahl an funktionsfähigen Zündern, wobei die Mindestanzahl kleiner ist als die Anzahl der Zünder oder Brenner, so kann die Startfreigabe der Gasturbine verweigert werden, was dazu führt, dass die Brennstoffzufuhr nicht unmittelbar geöffnet wird. Wenn beispielsweise die Mindestanzahl an funktionsfähigen Zündern nach der Off-Line-Verdichterwäsche nicht erreicht wird, bietet es sich an, die Zünder durch einen Vorheizvorgang zu trocknen. Danach kann ein weiterer Startversuch erfolgen. Gleichfalls ist es möglich, nach dem Durchführen einer Vorheizphase eine nochmalige Überprüfung jeden Zünders durchzuführen, um festzustellen, ob zwischenzeitlich eine ausreichende Anzahl an funktionsfähigen Zündern vorhanden ist. Dieses Verfahren bietet sich - unabhängig vom eingesetzten Verfahren zur Ermittelung des Zustands des Zünders - insbesondere bei Gasturbinen mit Ringbrennkammern an, bei denen eine Anzahl von Brennern in einen gemeinsamen Verbrennungsraum münden, wodurch eine Zündung von nicht gezündeten Brennern auch von derjenigen Flamme hervorgerufen werden kann, welche dem betreffenden Brenner unmittelbar benachbart ist.

Weitere Vorteile und Merkmale der Erfindung werden in der nachfolgenden Figurenbeschreibung aufgeführt. Dabei zeigen:
- FIG 1: einen schematische Plan einer Zündeinrichtung mit einer Messeinrichtung,
- FIG 2: den zeitlichen Verlauf des Zündstroms während der Zünddauer eines Zünders eines Brenners einer Gasturbine bei einer Rotordrehzahl von 2 Hz und
- FIG 3: den zeitlichen Verlauf des Zündstroms beim Hochfahren der Gasturbine.

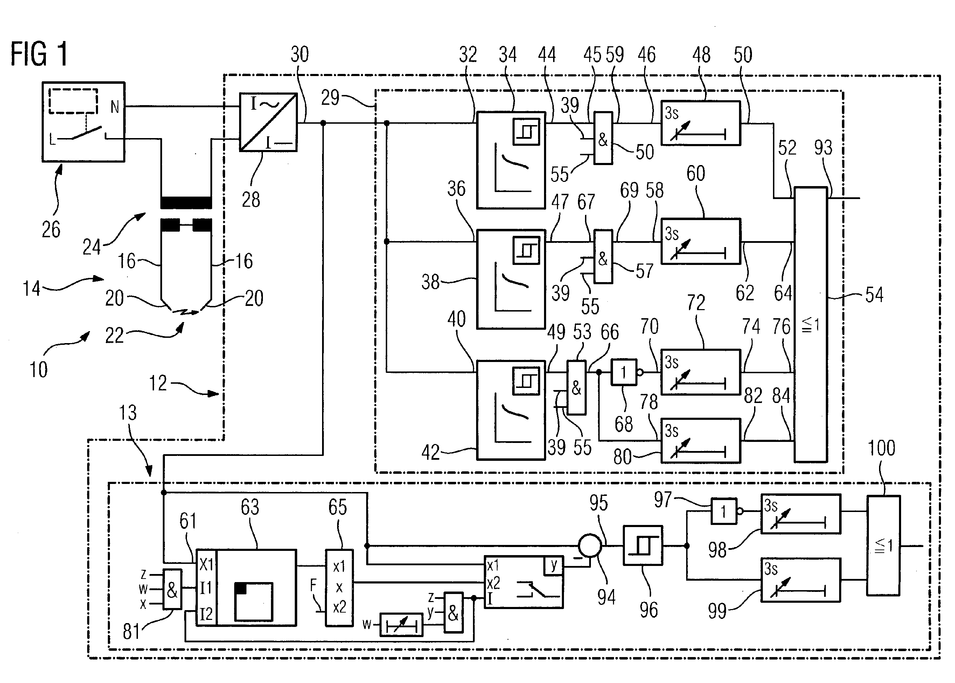

In FIG 1 ist eine Zündeinrichtung 10 sowie eine Messeinrichtung 12 zur Ermittlung eines Zustands eines elektrischen Zünders 14 eines Gasturbinenbrenners schematisch dargestellt. Die Zündeinrichtung 10 umfasst einen zwei einander gegenüberliegende Elektroden 16 aufweisenden Zünder 14, zwischen deren Elektrodenspitzen 20 ein Zündfunken 22 mittels einer an den Elektroden 16 anlegbaren Zündspannung erzeugbar ist. Die beiden Elektroden 16 sind mit einer Sekundärwicklung eines Zündtransformators 24 elektrisch verbunden. Die Primärwicklung des Zündtransformators 24 ist mit einer schaltbaren Wechselspannungsquelle 26 verbunden, wobei in Reihe zum Zündtransformator 24 ein Strommessumformer 28 als Sensor geschaltet ist, mittels dem ein den primärseitigen Zündstrom charakterisierendes Signal zur weiteren Verarbeitung erfasst werden kann. Ein primärseitiger Anschluss des Zündtransformators ist dabei über einen Schalter mit der Phase L elektrisch verbindbar, der andere Anschluss der Primärseite des Zündtransformators 24 ist über den Strommessumformer 28 mit dem Neutralleiter N verbunden. Die Elektroden 16 können dabei beispielsweise die Elektroden des Zünders eines Pilotbrenners oder Hauptbrenners einer Gasturbine sein, mit dem ein Brenngas, ein brennbares Brenngas-Luftgemisch oder ein Öl-Luftgemisch durch die Bereitstellung eines Zündfunkens 22 gezündet werden kann. Insbesondere kann dabei sowohl der Brenner als auch die Elektroden 16 gemäß der in der europäischen Patentanmeldung mit der Anmeldenummer 06017534.6 (veröffentlicht als EP 1 892 474 A1) gezeigten Ausgestaltung ausgebildet sein. Das den Zündstrom charakterisierende Signal wird am Ausgang 30 des Strommessumformers 28 bereitgestellt, alsbald der Schalter der Wechselspannungsquelle 26 geschlossen ist. Das charakterisierende Signal kann dann einer Auswerteeinheit 29 zugeführt werden, welche hauptsächlich drei Grenzwertmelder 34, 38, 42, drei Und-Gatter 50, 57, 53, vier Zeitglieder 48, 60, 72, 80 und ein Oder-Gatter 54 umfasst.

Im Detail ist der Ausgang 30 des Strommessumformers 28 mit einem Eingang 32 des ersten Grenzwertmelders 34 verbunden. Des Weiteren ist der Ausgang 30 mit einem Eingang 36 des zweiten Grenzwertmelders 38 und mit einem Eingang 40 des dritten Grenzwertmelders 42 verbunden. Der Ausgang 44 des ersten Grenzwertmelders 34 ist mit dem Eingang 45 des ersten Und-Gatters 50 verbunden, dessen Ausgang 59 über den Eingang 46 des Zeitglieds 48 und dessen Ausgang 50 mit dem Eingang 52 des Oder-Gatters 54 verbunden ist. Ein Ausgang 47 des zweiten Grenzwertmelders 38 ist mit einem Eingang 67 des zweiten Und-Gatters 57 verbunden, dessen Ausgang 69 über den Eingang 58 des zweiten Zeitglieds 60 und dessen Ausgang 62 wiederum mit einem Eingang 64 des Oder-Gatters 54 verbunden ist. Ein Ausgang 49 des dritten Grenzwertmelders 42 gelangt über das dritte Und-Gatter 53 und dessen Ausgang 66 über den Eingang des Inverters 68 zu einem Eingang 70 des dritten Zeitglieds 72, dessen Ausgang 74 mit einem Eingang 76 des Oder-Gatters 54 verbunden ist. Des Weiteren ist der Ausgang 66 des dritten Und-Gatters 53 mit einem Eingang 78 des vierten Zeitglieds 80 verbunden, dessen Ausgang 82 mit einem vierten Eingang 84 des Oder-Gatters 54 verbunden ist. Die drei Und-Gatter 50, 57, 53 sorgen als Freigabeverriegelung dafür, dass der zu überwachende Zündstrom mit den im Speicher hinterlegten Grenzwerten eines Referenzstroms (Sollstrom-Mittelwert) bei gleichen Umgebungsbedingungen verglichen und zu vergleichbaren Zeitpunkten gestartet werden kann. Auf die Eingänge 39, 55 der Und-Gatter 50, 57, 53 werden zu diesem Zweck jeweils Signale für "Drehzahl größer 5,5 Hz" und "Zündung Ein" geschaltet. Mit Hilfe der Bedingung, dass die Rotordrehzahl größer einer Grenzdrehzahl von 5,5 Hz (= 5,5 Hz x 60 Sek. = 330 min⁻¹) ist, kann überprüft werden, ob sich die Gasturbine im Hochfahrprozess (Rotordrehzahl ist kleiner 5,5 Hz) befindet oder nicht. Das Signal eines Ausgangs 93 des Oder-Gatters 54 wird einem Betreiber der Gasturbine angezeigt. Sofern ein logisch "1"-Signal dort ansteht, wird der Zustand des betreffenden Zünders 14 als nicht funktionsfähig dem Betreiber angezeigt. Sofern keine Off-Line-Verdichterwäsche unmittelbar vor der Überprüfung durchgeführt wurde, deutet dies auf einen defekten Zünder 14 hin.

Bei einer Drehzahl von 6,2 Hz wird mit dem Zuschalten der Zündspannung (= "Zündung ein") durch die schaltbare Wechselspannungsquelle 26 auf den Zündtransformator 24 das Verfahren zur Ermittelung des Zustands des Zünders 14 gestartet, indem ab diesem Zeitpunkt in jedem Grenzwertmelder 34, 38, 42 Vergleiche durchgeführt werden. Das vom Strommessumformer 28 an dessen Ausgang 30 bereitgestellte Signal, welches den primärseitigen Zündstrom repräsentiert, wird von dem ersten Grenzwertmelder 34 in Verbindung mit der Freigabeverriegelung durch das Und-Gatter 50 sowie dem ersten Zeitglied 48 überwacht. Im ersten Grenzwertmelder 34 ist zumindest ein oberer Grenzwert hinterlegt, welcher mit dem an dessen Eingang 32 anstehenden Signal verglichen wird. Der erste Grenzwert repräsentiert eine maximal zulässige Stromgröße des Zündstroms. Ist das anstehende Signal oberhalb des ersten Grenzwertes, so steht am Ausgang 44 des ersten Grenzwertmelders 34 ein logisch "1"-Signal an, welches über das Und-Gatter 50 von dem ersten Zeitglied 48 an dessen Ausgang 50 durchgereicht wird, sofern das logisch "1"-Signal für eine Mindestzeitdauer, beispielsweise 3 Sekunden am Eingang 46 des ersten Zeitglieds 48 ununterbrochen anliegt.

Der zweite Grenzwertmelder 38, das zweite Und-Gatter 57 und das zweite Zeitglied 60 arbeiten in analoger Weise, wobei jedoch das am Eingang 36 des zweiten Grenzwertmelders 38 anliegende, den Zündstrom charakterisierende Signal mit einem im zweiten Grenzwertmelder 38 gespeicherten zweiten Grenzwert verglichen wird, wobei der zweite Grenzwertmelder 38 ein logisch "1"-Signal an dessen Ausgang 47 bereitstellt, alsbald das charakterisierende Signal unterhalb des zweiten Grenzwertes liegt. Der zweite Grenzwert repräsentiert eine minimal zulässige Größe des Zündstroms.

Über das zweite Und-Gatter 57 sowie mit Hilfe des zweiten Zeitglieds 60 wird das vom Ausgang 47 bereitgestellte logisch "1"-Signal an das Oder-Gatter 54 durchgereicht, wenn dieses für eine Mindestdauer, beispielsweise 3 Sekunden am Eingang 58 des zweiten Zeitglieds 60 ununterbrochen ansteht.

Der dritte Grenzwertmelder 42 arbeitet in Verbindung mit dem dritten Und-Gatter 53, dem Inverter 68 und dem dritten und vierten Zeitglied 72, 80 in ebenfalls analoger Weise. Der Ausgang 74 des dritten Zeitglieds 72 und der Ausgang 82 des vierten Zeitglieds 80 führen jeweils ein logisch "0"-Signal, wenn das charakterisierende Signal am Eingang 40 des dritten Grenzwertmelders 42 nicht länger als eine Mindestdauer, beispielsweise drei Sekunden, ununterbrochen oberhalb oder unterhalb eines im dritten Grenzwertmelder 42 gespeicherten dritten Grenzwertes ansteht. Der dritte Grenzwert entspricht dem Sollstrom-Mittelwert, welcher mittig zwischen oberem und unterem Grenzwert liegt. Das am Eingang 40 anstehende Signal muss also um den dritten Grenzwert schwanken, damit die Ausgänge 74, 82 des dritten und vierten Zeitglieds 72, 80 stets logisch "0"-Signal führen. Bleibt der um den dritten Grenzwert schwankende Stromverlauf für länger als drei Sekunden aus, gibt eines der beiden Zeitglieder 72, 80 ein logisch "1"-Signal aus.

Am Ausgang 93 des Oder-Gatters 54 kann dann der Zustand des Zünders 14 erkannt werden, wobei bei Ausgabe eines logisch "1"-Signals der Zustand des Zünders 14 als nicht funktionsfähig definiert ist und bei Ausgabe eines logisch "0"-Signals der Zustand als funktionsfähig.

Die in den drei Grenzwertmelden 34, 38 und 42 gespeicherten Grenzwerte können dabei zeitabhängig sein, wobei der im ersten Grenzwertmelder 34 gespeicherte Grenzwert den oberen Grenzwert einer Sollstrom-Hüllkurve bildet, der im zweiten Grenzwertmelder 38 gespeicherte Grenzwert bildet den unteren Grenzwert der Sollstrom-Hüllkurve und der im dritten Grenzwertmelder 42 gespeicherte dritte Grenzwert stellt dann den Sollstrom-Mittelwert dar, um welchen der Zündstrom üblicherweise schwankt, sofern ein funktionsfähiger Zünder 14 vorliegt und die Zündspannung an den Elektrodenspitzen 20 ein Zündfunken 22 erzeugt. Insofern ist der erste und zweite Grenzwertmelder 34, 38 jeweils als Grenzwert-Komparator ausgebildet und der dritte Grenzwertmelder 42 als Komparator, welcher das an seinem Eingang 40 anstehende und den Stromverlauf des Zündstrom charakterisierenden-Signals auf einen schwankenden Verlauf überwacht.

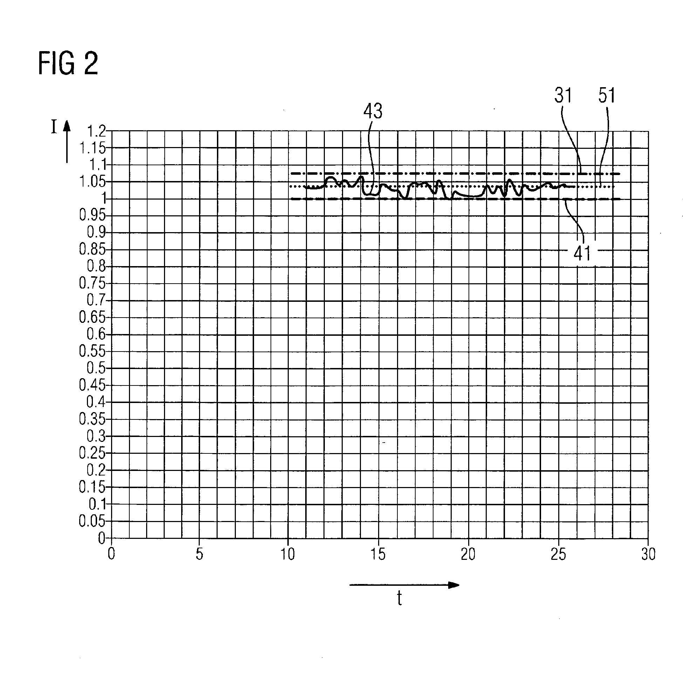

In FIG 2 ist ein beispielhafter Stromverlauf durch einen funktionsfähigen Zünder 14 des Brenners einer Gasturbine dargestellt. Dementsprechend ist auf der Abszisse eine Zeit aufgetragen, während auf der Ordinate der Zündstrom bzw. die Größe des diesen charakterisierenden Signals aufgetragen ist.

In FIG 2 ist der vom Strommessumformer 28 erfasste tatsächliche Stromverlauf in einer Linie 43 dargestellt. Der dargestellte Stromverlauf 43 spiegelt dabei ein Beispiel für einen Stromverlauf wider, welcher bei funktionsfähigen Zündern 14 auftritt.

Der Stromverlauf wurde bei besonders kleiner Rotordrehzahl ermittelt, beispielsweise 2 Hz, welche vor dem Start auftritt. Der Wert von 2 Hz entspricht einer Rotordrehzahl von 120 Umdrehungen pro Minute. Aufgrund der vergleichsweise geringen Rotordrehzahl der Gasturbine saugt der zur Gasturbine zugehörige Verdichter eine vergleichsweise geringe Menge an Luft an, wodurch die durch die Brenner und durch die Turbine gepumpte Luft ohne nennenswerten Einfluss auf einen an der Spitze 20 der Elektroden 16 angeordneten Zündfunken 22 ist. Sofern bei einer derartigen geringen Rotordrehzahl das erfindungsgemäße Verfahren durchgeführt wird, kann mit zeitlich konstanten Grenzwerten gearbeitet werden.

Das Verfahren sieht die Verwendung von drei Grenzwerten vor. Der erste Grenzwert, welcher auch als oberer Grenzwert bezeichnet werden kann, stellt dabei den maximal zulässigen Zündstrom des Zünders 14 dar. Die obere Grenzwert-Kennlinie ist in FIG 2 in einer strichpunktierten Linienart dargestellt und mit dem Bezugszeichen 31 versehen. Die obere Grenzwert-Kennlinie 31 gemäß FIG 2 zeigt einen zeitlich konstanten Grenzwert, welcher im ersten Grenzwertmelder 34 hinterlegt sein kann.

Der zweite Grenzwert, welcher auch als unterer Grenzwert bezeichnet werden kann, ist in gestrichelter Linienart dargestellt. Der gemäß FIG 2 zeitlich konstante Grenzwert ist mittels einer unteren Grenzwert-Kennlinie 41 dargestellt. Der obere Grenzwert 31 und der untere Grenzwert 41 bilden dabei eine Sollstrom-Hüllkurve bzw. Intervall, in welchem der tatsächlich auftretende Zündstrom bei einem funktionsfähigen Zünder 14 bei geringer Rotordrehzahl liegen muss bzw. liegt. Der dritte, ebenfalls zeitlich konstante Grenzwert, welcher den Sollstrom-Mittelwert darstellt, ist in FIG 2 in gepunkteter Linienart 51 gezeigt.

Aufgrund der vergleichsweise geringen Rotordrehzahl ist der Einfluss der an den Spitzen der Elektroden 16 vorbeiströmenden Luft auf den Zündfunken 22 vergleichsweise gering, so dass in den Grenzwertmeldern 34, 38 42 mit konstanten Grenzwerten 31, 41 und 51 die Funktionsfähigkeit des betreffenden Zünders überwacht werden kann.

Da der Zündfunke 22 des Zünders 14 als Lichtbogen ausgebildet ist, schwankt der Zündstrom und dessen charakterisierende Signal um den dritten Grenzwert 51, welcher mittig zwischen dem oberen und unteren Grenzwert 31, 41 liegt. Sofern der zufällig um den dritten Grenzwert 51 schwankende Stromverlauf 43 des Zündstroms sich nicht einstellt, deutet dies auf einen nichtfunktionsfähigen Zünder 14 hin.

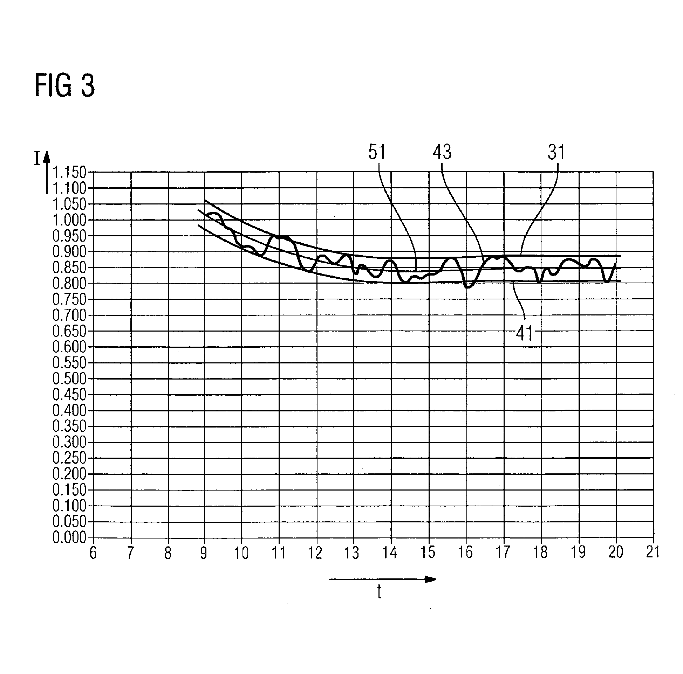

FIG 3 zeigt einen zu FIG 2 analoges Diagramm, bei dem auf der Abszisse die Zeit und auf der Ordinate der Zündstrom ausgetragen ist. Im Diagramm ist der erste, nun zeitabhängige oberer Grenzwert 31 dargestellt. Mit 41 ist der zweite, ebenfalls zeitabhängige Grenzwert dargestellt, welcher eine untere zulässige Grenze für den Zündstrom in Abhängigkeit von der Zeit darstellt. Der zeitabhängige obere Grenzwert 31 und zeitabhängige untere Grenzwert 41 bilden dabei eine Hüllkurve für den Sollstrom, in dem der tatsächlich auftretende, in seiner Größe jedoch zufällige Zündstrom variieren kann, sofern der Zünder 14 funktionsfähig ist. Mittig zwischen der oberen Grenzwert-Kennlinie 31 und unteren Grenzwert-Kennlinie 41 verläuft parallel dazu eine Sollstrom-Trend-Kennlinie 51, welche ebenfalls in ihrer Größe zeitabhängig ist.

Wird das erfindungsgemäße Verfahren zur Ermittlung des Zustands eines elektrischen Zünders 14 eines Gasturbinenbrenners während des Hochfahrprozesses der Gasturbine durchgeführt, bei dem sich die Rotordrehzahl stetig erhöht, so kann mit Hilfe der nunmehr zeitabhängigen Grenzwerte ein weiter verbessertes Verfahren zur Überwachung des Zünders 14 angegeben werden. Aufgrund der stetigen Erhöhungen der Rotordrehzahl des Rotors, welcher von einer externen Drehvorrichtung angetrieben wird, wird die vom Verdichter währenddessen angesaugte Luftmenge stetig vergrößert. Die vom Verdichter angesaugte Luftmenge wird dabei auch teilweise an den Zündern 14 des Gasturbinenbrenners vorbeigeführt, so dass sich die Umgebungsbedingungen des Zündfunkens mit zunehmender vorbeigeführter Luftmenge ebenfalls stetig ändern. Aufgrund der Änderung der Umgebungsbedingungen des Zündfunkens 22 ändert sich auch dessen Zündstrom. Um trotz des Hochfahrens der Gasturbine von einer geringen Rotordrehzahl, beispielsweise 2 Hz, auf eine größere Rotordrehzahl, beispielsweise 7,2 Hz, innerhalb von zehn Sekunden die Überprüfung des Zünders 14 auf Funktionsfähigkeit durchführen zu können, sind die dem Verfahren zugrunde liegenden Grenzwerte 31, 41, 51 als zeitabhängige Größen in den Grenzwertmeldern 34, 38, 42 gespeichert und den darin stetig ausgeführten Vergleichen zugrunde gelegt. Auch hier werden die Vergleiche ab demjenigen Zeitpunkt ausgeführt, ab dem mit dem Schalter der schaltbaren Wechselspannungsquelle 26 die Zündspannung an den Zündtransformator 24 angelegt wird.

Die Ermittlung der Grenzwerte 31, 41 und 51 kann beispielsweise nach dem Abschalten der Gasturbine, bei entsprechender Rotordrehzahl erfolgen. Hierzu wird einmal oder mehrfach eine Testzündung während des Anfahrens der Gasturbine durchgeführt, bei der sämtliche Brennstoffventile verschlossen bleiben und somit aus den Brennstoffaustritten kein brennbares Gemisch oder Brennstoff austritt. Für die Dauer der Testzündung wird der Zündstromverlauf ermittelt, aus dem mit Hilfe einer Interpolation unter Anwendung eines Polynoms dritten Grades eine Sollstrom-Trend-Kennlinie ermittelt werden kann. Durch das Ermitteln mehrerer solcher Sollstrom-Trend-Kennlinien und durch deren Mittlung können weitere zufällige Einflüsse ausgeschlossen werden. Der obere Grenzwert bzw. die obere Grenzwert-Kennlinie 31 und der untere Grenzwert bzw. die untere Grenzwert-Kennlinie 41 können dann durch einfache Parallelverschiebung, d. h. durch Addition oder Subtraktion einer zulässigen Stromabweichung des Zündstroms, bestimmt werden.

Anstelle des Vergleichs, ob der tatsächliche Zündstrom innerhalb der Hüllkurve liegt und um den Trendwert variiert, kann auch ein Mustervergleich von Stromverläufen durchgeführt werden, um festzustellen, ob der mit der Messeinrichtung 12 überwachte Zünder 14 funktionsfähig ist oder nicht.

Dem zur Folge kann die Messeinrichtung 12 alternativ zur Auswerteeinheit 29 oder ergänzend dazu eine Vorrichtung 13 zur Musterüberwachung aufweisen. Das den Zündstrom charakterisierende Signal des Strommessumformers 30 ist einem Eingang 61 eines beschreibbaren Wertespeichers 63 zuführbar. Mit Hilfe eines Multiplikatorelementes 65 können die im Wertespeicher 63 abgelegten Stromwerte bzw. die den ermittelten Stromverlauf repräsentierenden Werte mit einem Faktor F multipliziert werden, sofern ein späterer Vergleich der abgespeicherten Werte mit einem tatsächlichen Stromverlauf erfolgen soll, welcher bei einer anderen Rotordrehzahl als der, bei der die in Wertespeicher abgelegten Werte ermittelt wurden, durchgeführt wird.

Zum Zweck des Erfassens des Referenzverlaufs (Referenzmuster) wird der Zündstrom nach dem Abschalten einer Gasturbine (Auslaufbetrieb) ermittelt. Der Zündtransformator 24 wird dann bei einer konstanten Rotordrehzahl von 2 Hz, sobald die erreicht ist, für zehn Sekunden eingeschaltet. Währenddessen wird der Zündstrom kontinuierlich erfasst und dessen Verlauf als zeitabhängige Werte im Wertespeicher 63 gespeichert. Um die an Eingang X1 anstehenden Werte zu speichern, liegt währenddessen am Eingang I1 des Wertespeichers 63 ein logisch "1"-Signal an. Die Bedingungen zur Erfüllung des logisch "1"-Signals am Eingang I1 sind über ein Und-Gatter 81 verknüpft: dem Eingang X wird das Ergebnis der Bedingung "Austrittstemperatur noch größer als 100°C?" zugeführt, dem Eingang Z wird das Ergebnis "Zündung ein?" und dem Eingang W das Ergebnis "Waschen wurde vorher nicht durchgeführt?" zugeführt. Mit Hilfe der Erfassung hat man nun den Verlauf des Zündstroms eines funktionsfähigen Zünders 14 bei sogenannter Turn-Drehzahl 2 Hz des Rotors unter garantiert trockenen Verhältnissen, da die vom Verdichter angesaugte und bereitgestellte Luft noch größer 100°C heiß ist.

Der Mustervergleich kann insbesondere nach einer Off-Line-Verdichterwäsche durchgeführt werden. Der dann aktuell ermittelte Zündstrom wird über den Strommessumformer 30 einer Subtraktionsstelle 94 hinzugeführt, um den aktuell ermittelten Zündstrom mit den im Wertespeicher 63 hinterlegten Werte zu vergleichen, alsbald die Zündspannung (Z = logisch 1"-Signal) ansteht, das Waschen beendet (W = logisch "1"-Signal) ist und die Turn-Drehzahl (Y = logisch "1"-Signal) von 2 Hz wieder erreicht ist. Dann wird eine Differenzgröße am Ausgang 95 der Subtraktionsstelle 94 bereitgestellt, die um einen Nullpunkt schwankt, wenn der Verlauf des tatsächlichen Zündstroms und der Verlauf des gespeicherten Zündstroms sich ähneln, was auf einen funktionsfähigen Zünder 14 hindeutet. Mit Hilfe eines vierten Grenzwertmelders 96, eines Inverters 97, eines fünften Zeitglieds 98 und eines sechsten Zeitglieds 99 können Abweichungen von der Nulllinie ermittelt werden. Sollten die Abweichungen einseitig länger als eine vorbestimmte Zeitdauer anstehen, so wird von einem Oder-Gatter 100 durch Ausgabe eines logisch "1"-Signals der Zustand des Zünders 14 als nicht funktionsfähig gemeldet.

Sollte die Zündfähigkeit des betreffenden Zünders 14 durch das bei der Off-Line-Verdichterwäsche eingesetzte Wasser nun beeinträchtigt worden sein, können Kurzschlüsse entstehen, die einen konstanten Stromfluss zur Folge haben, der nicht um die Trendlinie alterniert und auch unter Umständen weit unter- oder oberhalb des unteren Grenzwertes oder oberen Grenzwertes zu finden ist. Durch die Kurzschlüsse mangelt es an einer an den Elektrodenspitzen 20 anstehenden Zündspannung, wodurch der Zündfunke auch ausbleibt. Zudem gibt es keine Beeinflussung durch den Luftmassenstrom, wodurch der alternierende Signalverlauf ausbleibt.

Wenn z.B. die Gasturbine mit mehreren Brennern ausgestattet ist, wobei jeder Brenner einen ihm zugeordneten Zünder 14 aufweist, und wobei die Brenner in einen gemeinsamen Verbrennungsraum in Form einer Ringbrennkammer münden, so kann die Startfreigabe der Gasturbine, was mit dem Öffnen der Brennstoffventile gleichzusetzen ist, verweigert werden, wenn nach einem Waschprogramm festgestellt wird, dass so viele Zünder 14 durch Feuchtigkeit in ihrer Funktion beeinträchtigt sind, dass ein Fehlstart der Gasturbine wahrscheinlich ist. Wird dieser Fehlerfall mit Hilfe von Zündvorrichtungen 10 festgestellt kann der Start der Gasturbine verschoben werden. Dann können die Zündelektroden 16 durch Vorheizen getrocknet werden. Das Vorheizen kann beispielsweise durch Einschalten des Zündtransformators 24 für eine Zeitdauer von ca. 30 Sekunden erreicht werden. Alternativ oder ergänzend dazu kann durch die Erhöhung des Luftmassenstroms (Kesselspülung) die Trocknung der noch wahrscheinlich feuchten Zünder eingeleitet werden. Wenn bei einer anschließenden, erneuten Testzündung resp. Testmessung eine ausreichende Anzahl von funktionsfähigen Zündern, beispielsweise 75% von der Zünderanzahl, erkannt wird, kann die Gasturbine ohne das Risiko einer Fehlzündung durch Zünderprobleme gestartet werden.

Insgesamt wird mit der Erfindung ein Verfahren zur Ermittlung eines Zustands eines elektrischen Zünders 14 eines Gasturbinenbrenners sowie eine Messeinrichtung 12 und eine Zündeinrichtung 10 für einen Gasturbinenbrenner angegeben, mittels dem Fehlstarts von Gasturbinen aufgrund nicht funktionsfähiger Zünder vermieden werden kann. Das Verfahren sieht vor, dass ein zeitabhängiges, den Zündstrom eines Zünders 14 charakterisierende Signal mit einem oberen Grenzwert und einem unteren Grenzwert zu vergleichen und gleichzeitig das charakterisierende Signal auf einen Sollstrom-Mittelwert zu vergleichen, um welchen der Zündstrom bei funktionsfähigem Zünder 14 zufällig schwanken soll.

## Patentansprüche

1. Verfahren zur Ermittelung eines Zustands eines elektrischen Zünders (14) eines Gasturbinenbrenners,
bei dem in einem ersten Schritt ein zeitabhängiges, den Zündstrom eines Zünders (14) charakterisierende Signal mit einem oberen Grenzwert und einem unteren Grenzwert verglichen wird,
**dadurch gekennzeichnet, dass**
das charakterisierende Signal die Größe des Zündstroms beschreibt und
in einem weiteren Schritt das charakterisierende Signal mit einem Sollstrom-Mittelwert verglichen wird, wobei der obere Grenzwert und der untere Grenzwert unter Bildung einer Sollstrom-Hüllkurve und/oder der Sollstrom-Mittelwert unter Bildung einer Sollstrom-Trend-Kennlinie (51) jeweils zeitabhängig sind.

2. Verfahren nach Anspruch 1,
bei dem der Zustand des Zünders (14) als nicht funktionsfähig ermittelt wird, wenn das charakterisierende Signal für eine erste Mindestdauer außerhalb des vom oberen Grenzwert und unteren Grenzwert gebildeten Intervalls liegt.

3. Verfahren nach Anspruch 1 oder 2,
bei dem der Zustand des Zünders (14) als nicht funktionsfähig ermittelt wird, wenn das charakterisierende Signal für eine zweite Mindestdauer nicht um den Sollstrom-Mittelwert resp. Sollstrom-Trend-Kennlinie (51) schwankt.

4. Verfahren nach einem der vorangehenden Ansprüche, bei dem ein Zündtransformator (24) zur Erzeugung einer Zündspannung für Zündelektroden (16) vorgesehen ist, wobei der primärseitige Strom des Zündtransformators (24) als Zündstrom erfasst wird.

5. Verfahren nach einem der vorangehenden Ansprüche, bei dem die Vergleiche mittels mehrerer Mustervergleiche von Stromverläufen durchgeführt werden.

6. Verfahren nach einem der vorangehenden Ansprüche, welches während der Drehung eines Rotors einer Gasturbine oder vor dem Starten der Gasturbine durchgeführt wird.

7. Verfahren nach Anspruch 6,
bei dem sich die Rotordrehzahl des Rotors ändert.

8. Verfahren nach einem der vorangehenden Ansprüche,
bei dem vorab der Stromverlauf eines funktionsfähigen Zünders (14) ermittelt wird,
aus welchem Stromverlauf die Sollstrom-Trend-Kennlinie (51) bestimmt wird.

9. Verfahren nach Anspruch 8,
bei dem der Stromverlauf des funktionsfähigen Zünders (14) nach dem Abschalten der Gasturbine erfasst wird.

10. Verfahren nach einem der vorangehenden Ansprüche,
bei dem in einem weiteren Schritt eine Anzahl von funktionsfähigen Zündern der Brenner der Gasturbine ermittelt wird und die Anzahl mit einer vorgegebenen Mindestanzahl von funktionsfähigen Zündern verglichen wird,
wobei, wenn eine Mindestanzahl an Zündern, welche Mindestanzahl kleiner ist als die Anzahl der Zünder oder Brenner, als funktionsfähig erkannt wird, in einem zeitlich daran anschließenden Schritt die Brennstoffzufuhr zu der Anzahl von Brennern der Gasturbine geöffnet wird.

11. Messeinrichtung (12) zur Ermittelung eines Zustands
eines elektrischen Zünders (14) eines Gasturbinenbrenners,
umfassend
einen Sensor (28) zur zeitaufgelösten Erfassung des Stroms eines elektrischen Zünders (14) eines Gasturbinenbrenners,
und eine mit dem Sensor (28) gekoppelte Auswerteeinrichtung (29) mit zumindest einem Speicher und mit zumindest einem Mittel zum Vergleichen des vom Sensor (28) bereitgestellten Signals mit zumindest einem im Speicher abgelegten Grenzwert, wobei in der Auswerteeinrichtung (29) drei in ihrer Größe unterschiedliche Werte gespeichert sind und drei Mittel zum Vergleich des Signals mit jeweils einem der drei Werte vorgesehen sind
**dadurch gekennzeichnet, dass**
zwei der drei Werte als zeitabhängige Grenzwerte eine Hüllkurve (31, 41) bilden und zwei der drei Mittel als Grenzwert-Komparatoren ausgebildet sind und
bei der einer der drei Werte als eine zeitabhängige Sollstrom-Trend-Kennlinie (51) und eines der drei Mittel als Komparator ausgebildet ist, welcher das Signal auf einen um die Sollstrom-Trend-Kennlinie schwankenden Verlauf überwacht.

12. Messeinrichtung (12) nach Anspruch 11,
bei der die Hüllkurve (31, 41) und/oder die Sollstrom-Trend-Kennlinie (51) in Form einer Kennlinie oder in Tabellenform abgelegt ist bzw. sind.

13. Zündeinrichtung (10) für einen Gasturbinenbrenner,
umfassend
einen zwei einander gegenüberliegende Elektroden (16) aufweisenden Zünder (14), zwischen deren Elektrodenspitzen (20) ein Zündfunken (22) mittels einer Zündspannung erzeugbar ist und
einen Zündtransformator (24) zur Erzeugung der Zündspannung, welcher Zündtransformator (24) sekundärseitig mit den Elektroden (16) elektrisch verbunden ist,
**dadurch gekennzeichnet, dass**
die Zündeinrichtung (10) eine Messeinrichtung (12) zur Ermittelung eines Zustands eines elektrischen Zünders (14) eines Gasturbinenbrenners nach einem der Ansprüche 11 bis 12 umfasst.

14. Zündeinrichtung (10) nach Anspruch 13,
bei dem der Sensor (28) der Messeinrichtung (12) primärseitig am Zündtransformator (24) angeordnet ist.

## Claims

1. Method for determining a state of an electric igniter (14) of a gas turbine burner,
in which in a first step a time-dependent signal, which characterizes the ignition current of an igniter (14) is compared with an upper limit value and a lower limit value,
**characterized in that**
the characterizing signal describes the magnitude of the ignition current and
in a further step the characterizing signal is compared with a set-point current mean value,
wherein in each case the upper limit value and the lower limit value are time-dependent, forming a set-point current envelope curve, and/or the set-point current mean value is time-dependent, forming a set-point current trend characteristic (51).

2. Method according to Claim 1,
in which the state of the igniter (14) is determined as being unserviceable if the characterizing signal lies outside the interval which is formed by the upper limit value and lower limit value for a first minimum duration.

3. Method according to Claim 1 or 2,
in which the state of the igniter (14) is determined as being unserviceable if the characterizing signal does not fluctuate around the set-point current mean value or set-point current trend characteristic (51) for a second minimum duration.

4. Method according to one of the preceding claims,
in which an ignition transformer (24) is provided for generating an ignition voltage for ignition electrodes (16), wherein the primary-side current of the ignition transformer (24) is measured as the ignition current.

5. Method according to one of the preceding claims,
in which the comparisons are carried out by means of a plurality of pattern comparisons of current flows.

6. Method according to one of the preceding claims,
which is carried out during the rotation of a rotor of a gas turbine or before starting the gas turbine.

7. Method according to Claim 6,
in which the speed of the rotor is changed.

8. Method according to one of the preceding claims,
in which the current flow of a serviceable igniter (14) is determined in advance,
from which current flow the set-point current trend characteristic (51) is determined.

9. Method according to Claim 8,
in which the current flow of the serviceable igniter (14) is measured after shutting down the gas turbine.

10. Method according to one of the preceding claims,
in which in a further step a number of serviceable igniters of the burners of the gas turbine are determined, and the number is compared with a prespecified minimum number of serviceable igniters,
wherein, if a minimum number of igniters, which minimum number is less than the number of igniters or burners, are identified as being serviceable, in a step subsequent to it in time the fuel feed to the number of burners of the gas turbine is opened.

11. Measuring device (12) for determining a state of an electric igniter (14) of a gas turbine burner,
comprising
a sensor (28) for time-resolved measurement of the current of an electric igniter (14) of a gas turbine burner,
and an evaluation device (29) which is connected to the sensor (28), with at least one memory and with at least one means for comparing the signal which is made available by the sensor (28) with at least one limit value which is stored in the memory, wherein in the evaluation device (29) three values, which differ in their magnitude, are stored, and three means are provided for comparing the signal with one of the three values in each case, **characterized in that**
two of the three values, as time-dependent limiting values, form an envelope curve (31, 41), and two of the three means are formed as limit-value comparators and
in which one of the three values is formed as a time-dependent set-point current trend characteristic (51) and one of the three means is formed as a comparator which monitors the signal for a flow which fluctuates around the set-point current trend characteristic.

12. Measuring device (12) according to Claim 11,
in which the envelope curve (31, 41) and/or the set-point current trend characteristic (51) is, or are, stored in the form of a characteristic line or in table form.

13. Ignition device (10) for a gas turbine burner,
comprising
an igniter (14) having two electrodes (16) disposed opposite each other, between the electrode tips (20) of which an ignition spark (22) can be generated by means of an ignition voltage, and
an ignition transformer (24) for generating the ignition voltage, which ignition transformer (24) is electrically connected on the secondary side to the electrodes (16), **characterized in that**
the ignition device (10) comprises a measuring device (12) for determining a state of an electric igniter (14) of a gas turbine burner according to one of Claims 11 to 12.

14. Ignition device (10) according to Claim 13,
in which the sensor (28) of the measuring device (12) is arranged on the primary side on the ignition transformer (24).

## Revendications

1. Procédé de détermination d'un état d'un allumeur ( 14 ) électrique d'un brûleur de turbine à gaz, dans lequel, dans un premier stade, un signal, dépendant du temps et caractérisant le courant d'allumage d'un allumeur ( 14 ), a une valeur limite supérieure et une valeur limite inférieure,
**caractérisé en ce que**
le signal caractérisant décrit la valeur du courant d'allumage et
dans un autre stade, on compare le signal caractérisant à une valeur moyenne de courant de consigne, la valeur limite supérieure et la valeur limite inférieure avec formation d'une courbe enveloppe de courant de consigne et/ou la valeur moyenne du courant de consigne avec formation d'une courbe ( 51 ) caractéristique, vers laquelle tend le courant de consigne, dépendant respectivement du temps.

2. Procédé suivant la revendication 1,
dans lequel on détermine l'état de l'allumeur ( 14 ) comme étant inapte à fonctionner, si le signal caractérisant se trouve pendant une première durée minimum à l'extérieur de l'intervalle formé par la valeur limite supérieure et par la valeur limite inférieure.

3. Procédé suivant la revendication 1 ou 2,
dans lequel on détermine l'état de l'allumeur ( 14 ) comme inapte à fonctionner, si le signal caractérisant ne fluctue pas pendant une deuxième durée minimum autour de la valeur moyenne de courant de consigne ou respectivement de la courbe ( 51 ) caractéristique, vers laquelle tend le courant de consigne.

4. Procédé suivant l'une des revendications précédentes,
dans lequel il est prévu un transformateur ( 24 ) d'allumage pour la production d'une tension d'allumage d'électrodes ( 16 ) d'allumage, le courant du côté primaire du transformateur ( 24 ) d'allumage étant détecté en tant que courant d'allumage.

5. Procédé suivant l'une des revendications précédentes,
dans lequel on effectue les comparaisons au moyen de plusieurs comparaisons de modèles de courbes de courant.

6. Procédé suivant l'une des revendications précédentes, qui s'effectue pendant la rotation d'un rotor d'une turbine à gaz ou avant le démarrage de la turbine à gaz.

7. Procédé suivant la revendication 6,
dans lequel la vitesse de rotation du rotor se modifie.

8. Procédé suivant l'une des revendications précédentes,
dans lequel on détermine auparavant la courbe de courant d'un allumage ( 14 ) apte à fonctionner,
à partir de laquelle on détermine la courbe ( 51 ) caractéristique, vers laquelle tend le courant de consigne.

9. Procédé suivant la revendication 8,
**caractérisé en ce qu'**on détecte la courbe de courant de l'allumeur ( 14 ) apte à fonctionner après l'arrêt de la turbine à gaz.

10. Procédé suivant l'une des revendications précédentes,
dans lequel, dans un autre stade, on détermine un nombre d'allumeurs aptes à fonctionner du brûleur de la turbine à gaz et on compare ce nombre à un nombre minimum donné à l'avance de brûleurs aptes à fonctionner
dans lequel, si un nombre minimum de brûleurs, lequel est plus petit que le nombre des allumeurs ou brûleurs, est reconnu comme apte à fonctionner, dans un stade venant ensuite dans le temps, on ouvre l'apport de combustible au nombre de brûleurs de la turbine à gaz.

11. Dispositif ( 12 ) de mesure pour la détermination d'un état d'un allumeur ( 14 ) électrique d'un brûleur de turbine à gaz
comprenant
un capteur ( 28 ) pour la détection avec résolution dans le temps du courant d'un allumeur ( 14 ) électrique d'un brûleur de turbine à gaz
et un dispositif ( 29 ) d'exploitation, couplé au capteur ( 28 ) et ayant au moins une mémoire et au moins un moyen de comparaison du signal fourni par le capteur ( 28 ) à au moins une valeur limite mémorisée dans la mémoire, dans lequel, il est mémorisé, dans le dispositif ( 29 ) d'exploitation, trois valeurs différentes dans leur dimension et trois moyens de comparaison du signal à respectivement l'une des trois valeurs,
**caractérisé en ce que**
deux des trois valeurs forment, en tant que valeurs limites qui dépendent du temps, une courbe ( 31, 41 ) enveloppe et deux des trois moyens sont conformés en comparateurs de valeur limite et dans lequel l'une des trois valeurs est conformée en courbe ( 51 ) caractéristique qui dépend du temps et vers laquelle tend le courant de consigne et l'un des trois moyens est constitué en comparateur qui contrôle la fluctuation du signal autour de la courbe caractéristique, vers laquelle tend le courant de consigne.

12. Dispositif ( 12 ) de mesure suivant la revendication 11, dans lequel la courbe ( 31, 41 ) enveloppe et/ou la courbe ( 51 ) caractéristique, vers laquelle tend le courant de consigne est ou sont mémorisés sous la forme d'une courbe caractéristique ou sous la forme d'une table.

13. Dispositif ( 10 ) d'allumage d'un brûleur d'une turbine à gaz,
comprenant
un allumeur ( 14 ) ayant deux électrodes ( 16 ) opposées l'une à l'autre, entre les pointes ( 20 ) d'électrodes desquelles une étincelle ( 22 ) d'allumage peut être produite au moyen d'une tension d'allumage et
un transformateur ( 24 ) d'allumage pour la production de la tension d'allumage, lequel transformateur ( 24 ) d'allumage est relié électriquement du côté secondaire aux électrodes ( 16 ),
**caractérisé en ce que**
le dispositif ( 10 ) d'allumage comprend un dispositif ( 12 ) de mesure pour la détermination d'un état d'un allumeur ( 14 ) électrique d'un brûleur de turbine à gaz suivant l'une des revendications 11 à 12.

14. Dispositif ( 10 ) d'allumage suivant la revendication 13, dans lequel le capteur ( 28 ) du dispositif ( 12 ) de mesure est monté du côté primaire sur le transformateur ( 24 ) d'allumage.
